# EUROPEAN PATENT APPLICATION

(11) **EP 2 704 218 A1**
(43) Date of publication of application: **05.03.2014**
(21) Application number: 13181865.0
(22) Date of filing: 27.08.2013
(51) Int. Cl.: H01L 33/40, H01L 33/32, H01L 33/38

(54) **Semiconductor light emitting device with a nitride semiconductor contact layer**

(30) Priority: 27.08.2012 KR 20120093943
(71) Applicant: LG Innotek Co., Ltd., Seoul 100-714 (KR)
(72) Inventor: Kwon, Oh Min, 100-714 Seoul (KR); Won, Jong Hak, 100-714 Seoul (KR); Seo, Heon Jin, 100-714 SEOUL (KR)
(74) Representative: Cabinet Plasseraud

(57) **Abstract**

Disclosed is a light emitting device including a light emitting structure (9) including at least a first conductive semiconductor layer (3), an active layer (5), and a second conductive semiconductor layer (7), an electrode layer (13) on the light emitting structure, and a contact layer (11) between the light emitting structure and the electrode layer and including a nitride semiconductor layer.

## Description

### BACKGROUND

The embodiment relates to a light emitting device.

Light emitting diodes (LEDs) are semiconductor light emitting devices to convert electrical energy into light energy to generate light.

Since the light emitting device may obtain high-brightness light and may have a semi-permanent life span, the light emitting device has been extensively used as a light source for a display, a vehicle, or a lighting device.

### SUMMARY

The embodiment provides a light emitting device capable of lowering a driving voltage to reduce power consumption.

The embodiment provides a light emitting device capable of increasing the intensity of light and light emission efficiency.

The embodiment provides a light emitting device capable of improving light extraction efficiency.

According to the embodiment, there is provided a light emitting device including a light emitting structure including at least a first conductive semiconductor layer, an active layer, and a second conductive semiconductor layer, an electrode layer on the light emitting structure, and a contact layer between the light emitting structure and the electrode layer and including a nitride semiconductor layer.

According to the embodiment, there is provided a light emitting device including a substrate, a light emitting structure on the substrate and including at least a first conductive semiconductor layer, an active layer, and a second conductive semiconductor layer, an electrode layer on the light emitting structure, and a contact layer between the light emitting structure and the electrode layer and including a nitride semiconductor layer. The contact layer is partially formed on the second conductive semiconductor layer.

According to the embodiment, there is provided a light emitting device including a light emitting structure including at least a first conductive semiconductor layer, an active layer, and a second conductive semiconductor layer, a contact layer on the light emitting structure and including a nitride semiconductor layer, an electrode layer on the light emitting structure, and a concave-convex structure between the contact layer and the electrode layer.

### BRIEF DESCRIPTION OF THE DRAWINGS

FIG. 1 is a sectional view showing a light emitting device according to a first embodiment.

FIG. 2 is a graph showing the variation of driving voltage according to the first embodiment.

FIG. 3 is a histogram showing the variation of optical power according to the first embodiment.

FIG. 4 is a graph showing the variation of the optical power according to the thickness of a contact layer and the growth temperature of the contact layer.

FIG. 5 is a sectional view showing a light emitting device according to a second embodiment.

FIG. 6 is a plan view showing one shape of an electrode layer of FIG. 5.

FIG. 7 is a plan view showing another shape of the electrode layer of FIG. 5.

FIG. 8 is a sectional view showing a light emitting device according to a third embodiment.

FIG. 9 is a sectional view showing a light emitting device according to a fourth embodiment.

FIG. 10 is a sectional view showing a light emitting device according to a fifth embodiment.

FIG. 11 is a sectional view showing a light emitting device according to a sixth embodiment.

FIG. 12 is a sectional view showing a light emitting device according to a seventh embodiment.

FIG. 13 is a sectional view showing a lateral-type light emitting device according to the first embodiment.

### DETAILED DESCRIPTION OF THE EMBODIMENTS

In the following description of the embodiments, it will be understood that, when a layer film, a region, a pattern or a structure is referred to as being "on" or "under" another substrate, layer film, region, pad or pattern, it can be "directly" or "indirectly" on the other substrate, layer film, region, pad, or pattern, or one or more intervening layers may also be present. Such a position of each layer will be described with reference to the drawings.

Hereinafter, the embodiment will be described with reference to accompanying drawings. The thickness and size of each layer film shown in the drawings may be exaggerated, omitted, or schematically shown for the purpose of convenience or clarity. In addition, the size of each component does not utterly reflect an actual size.

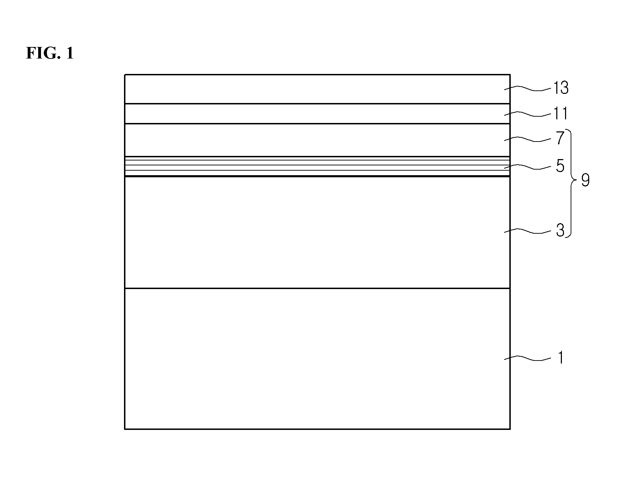

FIG. 1 is a sectional view showing a light emitting device according to a first embodiment.

Referring to FIG. 1, a light emitting device according to the first embodiment may include a substrate 1, a light emitting structure 9 provided on the substrate 1, an electrode layer 13 provided on the light emitting structure 9, and a contact layer 11 interposed between the light emitting structure 9 and the electrode layer 13.

The contact layer 11 may be named by a contact structure. In other words, the contact layer 11 and the contact structure not only substantially have the same function and the same structure, but also may substantially the same material.

Since the substrate 11 performs a support function, the substrate 11 must have a great stiffness, corrosion-resistance, and a low thermal expansion coefficient, and may include a material having a low lattice constant difference from that of the light emitting structure 9. For example, the substrate 1 may include at least one selected from the group consisting of sapphire, SiC, Si, GaAs, GaN, ZnO, GaP, InP and Ge, but the embodiment is not limited thereto.

Although not shown, a buffer layer may be interposed between the substrate 1 and the light emitting structure 9, but the embodiment is not limited thereto.

The buffer layer may be formed to reduce the great lattice constant difference between the substrate 1 and the light emitting structure 9. In other words, the buffer layer may be formed on the substrate 1, and the light emitting structure 9 may be formed on the buffer layer. In this case, since the light emitting structure 9 represents a less lattice constant difference from the buffer layer, the light emitting structure 9 is stably grown on the buffer layer without the failure, so that the electrical and optical characteristics can be improved.

For example, the buffer layer may have an intermediate lattice constant between the lattice constants of the substrate 1 and the light emitting structure 9.

The light emitting structure 9 may include a plurality of compound semiconductor layers including at least a first conductive semiconductor layer 3, an active layer 5, and a second conductive semiconductor layer 7. For example, a third semiconductor layer may be provided under the first conductive semiconductor layer 3 and a fourth semiconductor layer may be provided above the second conductive semiconductor layer 7. At least one of the third semiconductor layer and the fourth semiconductor layer may include dopants or may not include dopants.

Although not shown, the light emitting structure 9 may further include an electron blocking layer, but the embodiment is not limited thereto. The electron blocking layer is interposed between the active layer 5 and the second conductive semiconductor layer 7 to block first carriers i.e., electrons, which are generated from the first conductive semiconductor layer 3 and supplied to the active layer 5, from being transferred to the second conductive semiconductor layer 7 without staying the active layer 5. For example, the electron blocking layer may be formed on the active layer 5, and the second conductive semiconductor layer 7 may be formed on the electron blocking layer.

Referring to FIG. 1, the active layer 5 may be provided on the first conductive semiconductor layer 3, and the second conductive semiconductor layer 7 may be provided on the active layer 5.

The first conductive semiconductor layer 3, the active layer 5, and the second conductive semiconductor layer 7 may be sequentially formed on the substrate 1 through a growth process. The growth process may be performed by using MOCVD Metal-Organic Chemical Vapor Deposition or MBE Molecular Beam Epitaxy, but the embodiment is not limited thereto.

The buffer layer, the first conductive semiconductor layer 3, the active layer 5, the electron blocking layer, the second conductive semiconductor layer 7, and the third and fourth semiconductor layers may include a group II- VI or III-V compound semiconductor material.

The buffer layer, the first conductive semiconductor layer 3, the active layer 5, the electron blocking layer, the second conductive semiconductor layer 7, and the third and fourth semiconductor layers may include nitride semiconductor layers.

For example, the buffer layer may include a single layer or a plurality of layers including a material selected from the group consisting of GaN, AlN, InN, AlGaN and InGaN. For example, the first conductive semiconductor layer 3, the active layer 5, and the second conductive semiconductor layer 7 may include at least one selected from the group consisting of InAlGaN, GaN, AlGaN, InGaN, AlN, InN and AlInN.

For example, the first conductive semiconductor layer 3 may be an N type semiconductor layer including N type dopants, and the second conductive semiconductor layer 7 may be a P type semiconductor layer including P type dopants, but the embodiment is not limited thereto. The N type dopants may include Si, Ge, or Sn, and the P type dopants may include Mg, Zn, Ca, Sr, or Ba.

For example, the first conductive semiconductor layer 3 may include the doping concentration of 4×10¹⁸ cm⁻³ to 8×10¹⁸ cm⁻³, and the second conductive semiconductor layer 7 may include the doping concentration of 8×10¹⁹ cm⁻³ to 3×10²⁰ cm⁻³, but the embodiment is not limited thereto.

The first conductive semiconductor layer 3 may include a plurality of semiconductor layers including the same compound semiconductor material or compound semiconductor materials different from each other.

The second conductive semiconductor layer 7 may include a plurality of semiconductor layers including the same compound semiconductor material or compound semiconductor materials different from each other.

If the first and second conductive semiconductor layers 3 and 7 include the same compound semiconductor material, the semiconductor layers may have contain the different contents of compound semiconductor materials.

The active layer 5 may generate light having a wavelength corresponding to the energy bandgap difference varied depending on a material constituting the active layer 5 through the recombination of first carriers (e.g., electrons), which are injected from the first conductive semiconductor layer 3, and second carriers (e.g., holes) injected through the second conductive semiconductor layer 7.

The active layer 5 may include one of a multi quantum well (MQW) structure, a quantum dot structure, or a quantum wire structure. The active layer 5 may be formed by repeatedly laminating one cycle of well and barrier layers. The number of times to repeat the cycle of the well and barrier layers may vary depending on the characteristics of the light emitting device.

For example, the active layer 5 may include one of a cycle of InGaN/GaN, plural cycles of InGaN/AlGaN, a cycle of InGaN/InGaN, and a cycle of AlGaN/AlGaN. The bandgap of the barrier layer may be great than that of the well layer.

The light emitting device according to the first embodiment may be employed in a light emitting device having a lateral-type structure. In addition, the light emitting device according to the first embodiment may be employed in a light emitting device having a flip-chip type structure or a light emitting device having a vertical structure.

The electrode layer 13 may be provided on the light emitting structure 9. The electrode layer 13 may include a transmissive conductive material or a reflective conductive material, but the embodiment is not limited thereto.

For example, the transmissive conductive material may include one selected from the group consisting of ITO, IZO In-ZnO, GZO Ga-ZnO, AZO Al-ZnO, AGZO Al-Ga ZnO, IGZO In-Ga ZnO, IrOₓ, RuOₓ, RuOx/ITO, Ni/IrOx/Au and Ni/IrOx/Au/ITO, or the lamination layers thereof, but the embodiment is not limited thereto.

For example, the reflective conductive material may include one selected from the group consisting of Ag, Ni, Al, Rh, Pd, Ir, Ru, Mg, Zn, Pt, Au and Hf, or the lamination layers thereof, but the embodiment is not limited thereto.

For example, if the electrode layer 13 includes a transmissive conductive material, the light generated from the active layer 5 of the light emitting structure 9 may be transmitted through the electrode layer 13 and directed upward. In the lateral-type light emitting device, the electrode layer 13 including the transmissive conductive material may be used.

If the electrode layer 13 includes the reflective conductive material, the light generated from the active layer 5 of the light emitting structure 9 may be reflected by the electrode layer 13 and directed downward. In the light emitting device having a flip-chip type structure or a vertical structure, the electrode layer 13 including the reflective conductive material may be used.

Accordingly, the electrode layer 13 may include a transmissive conductive material or a reflective conductive material according to the directions of an exit surface of light.

The electrode layer 13 may include a transmissive conductive material in the light emitting device according to the first embodiment for the convenience of explanation, but the embodiment is not limited thereto.

The electrode layer 13 allows current to flow through an entire region of the electrode layer 13, that is, in a horizontal direction and allows current to flow from the electrode layer 13 to the second conductive semiconductor layer 7, that is, in a vertical direction, so that the current can uniformly flow through an entire region of the active layer 5 of the light emitting structure 9.

To this end, the electrode layer 13 has a conductive characteristic allowing current to flow while the electrode layer 13 may include a transmissive conductive material to transmit light.

Accordingly, if power is supplied to the electrode layer 13, current can be spread through the entire region of the electrode layer 13 by the power. Since the current spread through the entire region of the electrode layer 13 flows to the light emitting structure in a vertical direction, current uniformly flows through the entire region of the active layer 5 of the light emitting structure 9. Accordingly, since light having uniform brightness or uniform intensity is generated through the entire region of the active layer 5, the light emission efficiency can be improved.

If the electrode layer 13 is not formed, a pattern-shape electrode (not shown) having a rectangular shape or a circle shape makes partially contact with the second conductive semiconductor layer 7. The pattern-shape electrode is not formed through the entire region of the second conductive semiconductor layer 7, but formed at a portion of the second conductive semiconductor layer 7. Therefore, since the current mainly flows to the active layer 5 of the light emitting structure 9 perpendicularly to the pattern-shape electrode, the light is concentratedly generated only in the region of the active layer 5 and not generated in the remaining region of the active layer 5. Accordingly, the light is not only generated irregularly, but the whole light emission efficiency may be significantly degraded.

The contact layer 11 may be interposed between the light emitting structure 9 and the electrode layer 13. In detail, the contact layer 11 may be interposed between the second conductive semiconductor layer 7 and the electrode layer 13. If another semiconductor layer is provided on the second conductive semiconductor layer 7, the contact layer 11 may be interposed between the other semiconductor layer and the electrode layer 13.

The contact layer 11 minimizes contact resistance between the electrode layer 13 and the light emitting structure 9.

In other words, since the contact resistance between the electrode layer 13 and the light emitting structure 9 can be minimized by the contact layer 11, current can be more easily introduced from the electrode layer 13 to the light emitting structure 9. Accordingly, light can be generated by lower driving voltage while having the same brightness as that of the light emitting device having no the contact layer 11.

According to the first embodiment, even if the light emitting device having the contact layer 11 has driving voltage lower than that of the light emitting device having no contact layer 11, the light emitting device having the contact layer 11 can obtain light having the same brightness as that of the light emitting device having no contact layer 11.

The contact layer 11 may include group II-VI or III-V compound semiconductor materials similarly to the light emitting structure 9. The contact layer 11 may include a nitride semiconductor layer.

In the contact layer 11, dopants may be added to the group II-VI or III-V compound semiconductor materials in order to obtain the conductive characteristics. The dopants may include P type dopants or N type dopants as described above.

For example, the contact layer 11 may include at least one selected from the group consisting of InAlGaN, GaN, AlGaN, InGaN, AlN, InN and AlInN. For example, the N type dopants may include Si, Ge, or Sn, and the P type dopants may include Mg, Zn, Ca, Sr, or Ba.

The contact layer 11 includes a nitride semiconductor layer, so that the contact layer 11 may be sequentially formed with the buffer layer grown and the light emitting structure 9 on the substrate 1 using the same growth equipments as described above, the embodiment is not limited thereto.

The contact layer 11 may include dopants the same as dopants doped into one of the first and second conductive semiconductor layers 3 and 7.

The contact layer 11 may include dopants having the same polarity as polarities of dopants constituting one of the first and second conductive semiconductor layers 3 and 7. For example, although both of the contact layer 11 and the first conductive semiconductor layer 3 may include N type dopants, the embodiment is not limited thereto.

Although the contact layer 11 may include a semiconductor material the same as that constituting one of the first and second conductive semiconductor layers 3 and 7, the embodiment is not limited thereto. For example, the contact layer 11 may include GaN, and one of the first and second conductive semiconductor layers 3 and 7 may include GaN.

The contact layer 11 may be formed on the entire region of the second conductive semiconductor layer 7. In other words, the contact layer 11 may have the same size as that of at least the second conductive semiconductor layer 7.

The driving voltage or the light intensity of the contact layer 11 may be varied according to the thickness, the doping concentration and/or the growth temperature.

According to the first embodiment, the optimal condition of the contact layer 11 capable of lowering the driving voltage and increasing the light intensity is obtained.

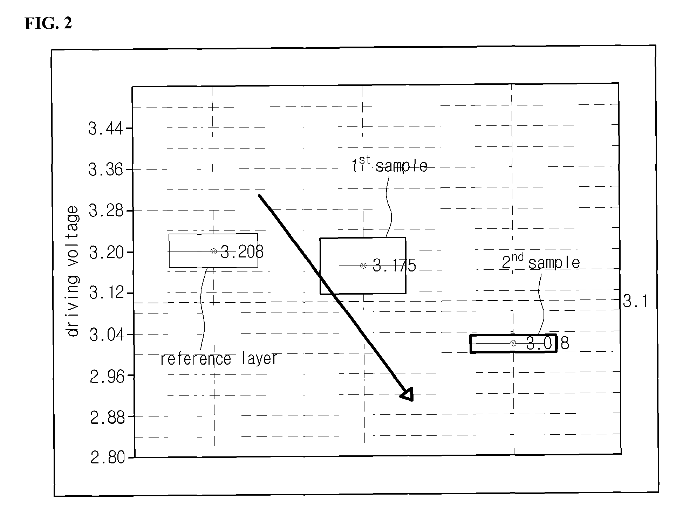

When the contact layer 11 may have the thickness of 15 Å to 30 Å as shown in FIG. 2, the driving voltage is lowered. Preferably, for example, the contact layer 11 may have the thickness of 20 Å to 25 Å.

A first sample represents a contact layer 11 having the thickness twice greater than that of the reference sample, and a second sample represents a contact layer 11 having the thickness three times greater than that of a reference sample.

The driving voltage of the reference sample is 3.208 V. On the contrary, the driving voltage of the first sample is 3.175V, and the driving voltage of the second sample is 3.018V.

Accordingly, as the thickness of the contact layer 11 is increased, the driving voltage is lowered.

However, as the thickness of the contact layer 11 is increased, the intensity of the light is lowered. Accordingly, preferably, the maximum thickness of the contact layer 11 is 30 Å. In other words, if the thickness of the contact layer 11 is more than 30 Å, the driving voltage may be lowered, but the intensity of light may be lowered.

For example, as the doping concentration of the contact layer 11 is increased, the intensity of light may be increased.

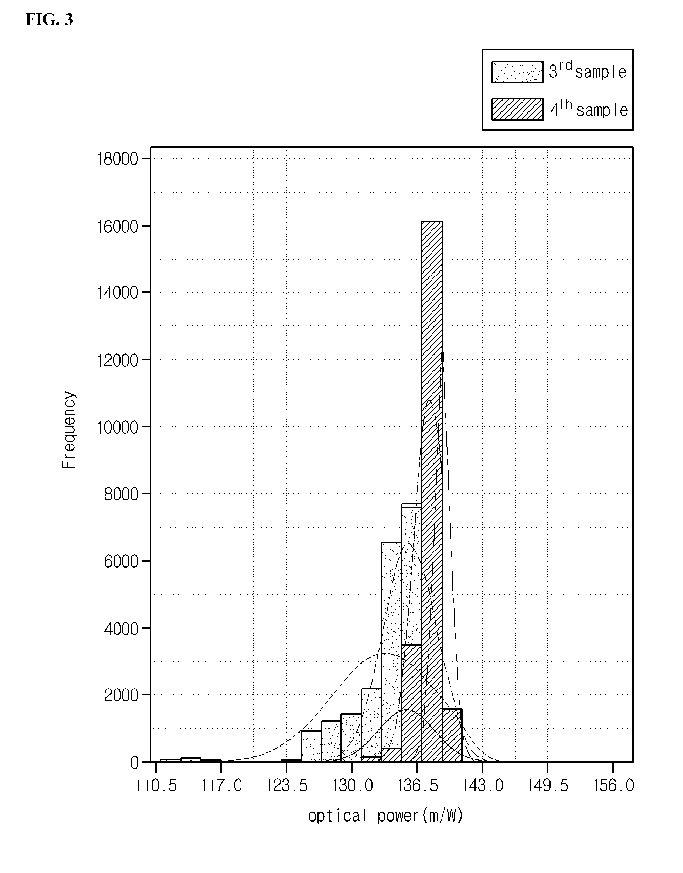

As shown in FIG. 3, two samples (the third sample and the fourth sample) are used to perform an experiment.

Although the reference sample is not shown in FIG. 3, the reference sample of FIG. 3 may have the same condition as that of the reference sample of FIG. 2.

The third sample represents the contact layer 11 having the thickness three times greater than that of the reference sample, and the fourth sample represents the contact layer 11 having the concentration twice higher than that of the reference sample.

The third sample represents the high frequency at the optical power of about 134 mW, while the fourth sample represents the high frequency at the optical power of about 142 mW.

According to the light emitting device of the first embodiment, the contact layer may have the doping concentration of 0.7×10¹⁸ cm⁻³ to 3×10¹⁸ cm⁻³, but the embodiment is not limited thereto. Preferably, the contact layer 11 may have the doping concentration of 1.5×10¹⁸ cm⁻³ to 2.5×10¹⁸ cm⁻³. In more detail, the contact layer 11 may have the doping concentration of 2.0×10¹⁸ cm⁻³, but the embodiment is not limited thereto.

The optical power of the contact layer 11 may be varied according to the growth temperature.

For example, the contact layer 11 may have the growth temperature of 660°C to 700°C, but the embodiment is not limited thereto. Preferably, the contact layer 11 may have the growth temperature of 670°C to 685°C. More preferably, the contact layer 11 may have the growth temperature of 680°C.

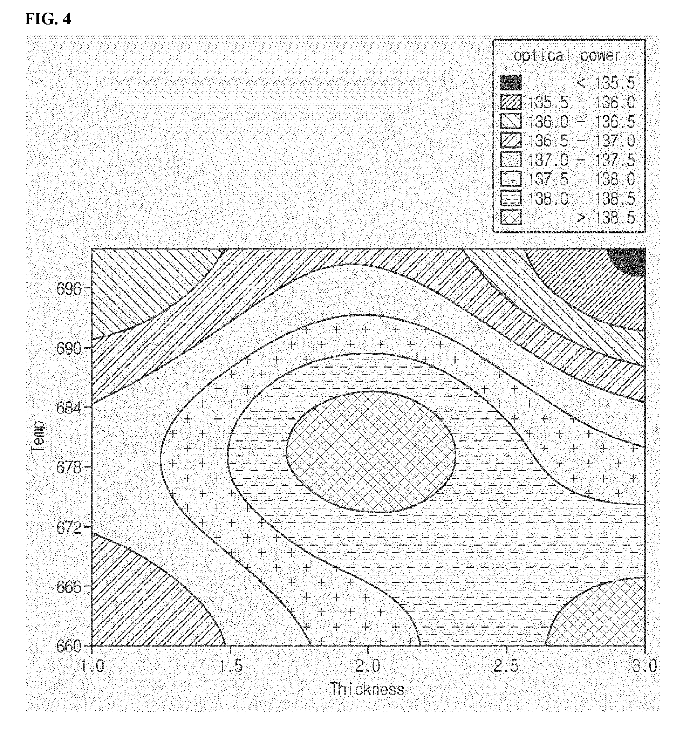

As shown in FIG. 4, the contact layer 11 may obtain the maximum optical power at the doping concentration of 0.7×10¹⁸ cm⁻³ to 3×10¹⁸ cm⁻³, the growth temperature of 660°C to 700°C, and the thickness of 15 Å to 30 Å.

As the optical power is increased, the intensity of light is increased. Therefore, according to the embodiment, the optimal growth temperature, the optimal thickness and/or the optimal doping concentration may increase the intensity of light as the optical power is increased.

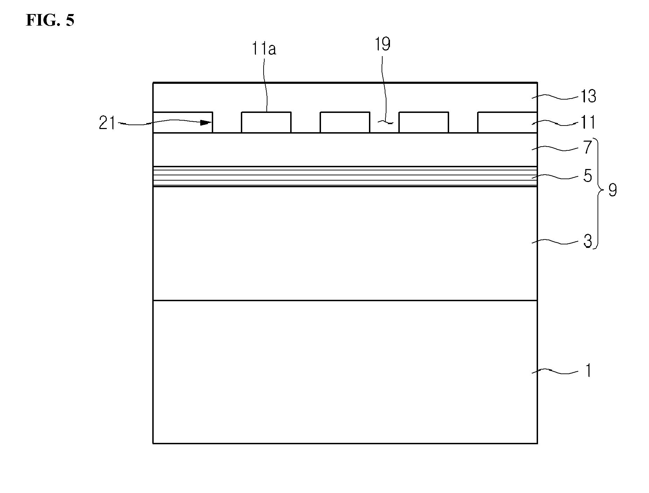

FIG. 5 is a sectional view showing a light emitting device according to the second embodiment.

The second embodiment is similar to the first embodiment except that the contact layer 11 is partially formed. The same reference numerals will be assigned to elements according to the second embodiment having functions, shapes and/or materials the same as those of elements according to the first embodiment, and the details thereof will be omitted.

Referring to FIG. 5, the light emitting device according to the second embodiment may include the substrate 1, the light emitting structure 9, the contact layer 11, and the electrode layer 13.

The contact layer 11 may be provided on the second conductive semiconductor layer 7 of the light emitting structure 9. The contact layer 11 may be interposed between the electrode layer 13 and the second conductive semiconductor layer 7 of the light emitting structure 9.

The electrode layer 13 may make contact with the second conductive semiconductor layer 7 through the contact layer 11.

A portion of the electrode layer 13 may make contact with the second conductive semiconductor layer 7 and another portion of the electrode layer 13 may make contact with the contact layer 11.

The contact layer 11 may include a plurality of holes 21 formed among a plurality of patterns 11a. In this case, the hole 21 is formed by completely perforating top and bottom surfaces of the contact layer 11.

The contact layer 11 including the patterns 11a and the holes 21 may be formed by patterning a compound semiconductor layer through a patterning process after growing the compound semiconductor layer on the entire region of the second conductive semiconductor layer 7

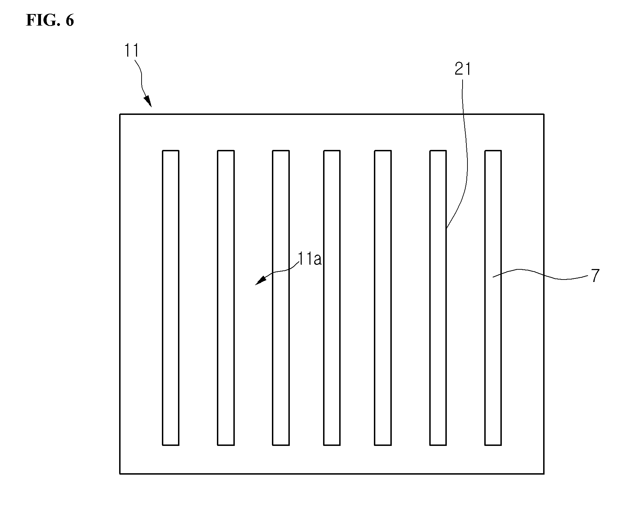

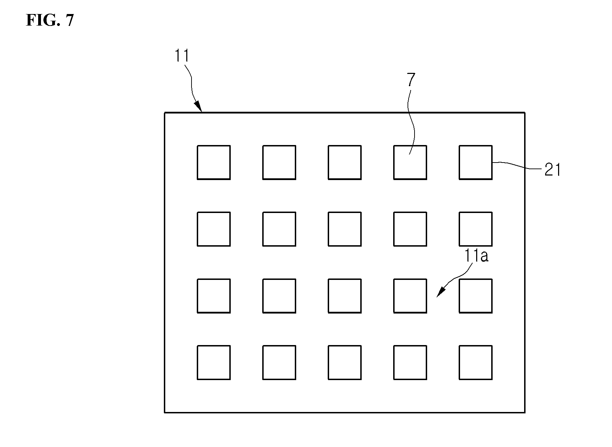

Although the pattern 11a and the hole 21 of the contact layer 11 may have the shapes shown in FIGS. 6 and 7, the embodiment is not limited thereto.

As illustrated in FIG. 6, the contact layer 11 may be formed in a stripe shape. Each hole 21 of the contact layer 11 may be longitudinally formed in one direction, and the pattern 11a may be formed between the holes 21. The adjacent patterns 11a may be connected to each other. The adjacent patterns 11a may be connected to each other on at least one side thereof. The adjacent patterns 11a may be spaced apart from each other by the hole 21. The top surface of the second conductive semiconductor layer 7 may be partially exposed by the hole 21 of the contact layer 11.

As shown in FIG. 7, the contact layer 11 may be formed in a lattice shape or a grid shape.

The contact layer 11 may include the holes 21 having a rectangular shape and the patterns 11a connected to each other to surround the holes 21.

The electrode layer 13 may make contact with the top surface of the second conductive semiconductor layer 7 through the hole 21.

The bottom surface of the electrode layer 13 may have a concave-convex structure including a plurality of protrusions 19. The bottom surface of the protrusion 19 of the electrode layer 13 may make contact with the second conductive semiconductor layer 7, and the lateral side of the protrusion 19 of the electrode layer 13 may make contact with an inner lateral side of the hole 21. In addition, the bottom surfaces of the electrode layer 13 except for the protrusions 19 may make contact with the top surface of the contact layer 11.

The protrusions 19 are formed on the bottom surfaces of the electrode layer 13 to increase the contact area between the contact layer 11 and the second conductive semiconductor layer 7, thereby preventing the electrode layer 13 from peeling off the light emitting structure 9. In addition, as the concave-convex structure is formed on the bottom surface of the electrode layer 13, light can be more easily extracted to the outside, so that the light extraction efficiency can be improved.

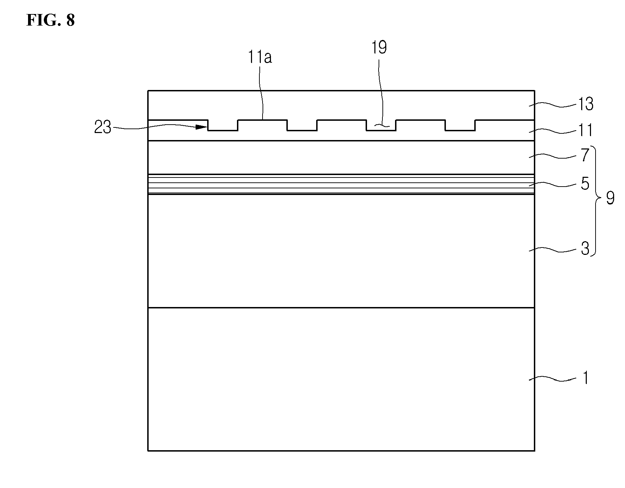

FIG. 8 is a sectional view showing a light emitting device according to the third embodiment.

The third embodiment is similar to the first embodiment or the second embodiment except that the contact layer 11 includes a plurality of grooves 23. The same reference numerals will be assigned to elements according to the third embodiment having functions, shapes and/or materials the same as those of elements according to the first or second embodiment, and the details thereof will be omitted.

Referring to FIG. 8, the light emitting device according to the third embodiment may include the substrate 1, the light emitting structure 9, the contact layer 11, and the electrode layer 13.

The contact layer 11 may be provided on the second conductive semiconductor layer 7 of the light emitting structure 9. The contact layer 11 may be provided between the electrode layer 13 and the second conductive semiconductor layer 7 of the light emitting structure 9.

The contact layer 11 may include the grooves 23 formed among the patterns 11a. In this case, the groove 23 may have the shape recessed inward of the top surface of the contact layer 11. In other words, the groove 23 may have a shape recessed by a predetermined depth from the top surface of the contact layer 11 instead of perforating top and bottom surfaces of the contact layer 11.

The depth of the groove 23 may be in the range of 30% to 90% with respect to the thickness of the contact layer 11. If the depth of the groove 23 is equal to or less than 30% with respect to the thickness of the contact layer 11, the contact area between the electrode layer 13 and the contact layer 11 is reduced, so that the contact performance may be degraded. If the depth of the groove 23 is equal to or greater than 90% with respect to the thickness of the contact layer 11, the thickness of the area between the bottom surface of the groove 23 and the bottom surface of the contact layer 11 is reduced, so that current may not smoothly flow through the area. Accordingly, current may not be smoothly introduced into the second conductive semiconductor layer 7 from the area between the bottom surface of the groove 23 and the bottom surface of the contact layer 11. Preferably, the depth of the groove 23 may be in the range of 50% to 70% with respect to the thickness of the contact layer 11.

Although the groove 23 has a stripe shape or a lattice shape similarly to the shape of the hole 21 according to the second embodiment, the embodiment is not limited thereto.

The top surface of the contact layer 11 may a concave-convex structure including a plurality of patterns 11a and a plurality of grooves 23.

The bottom surface of the electrode layer 13 may have the concave-convex structure having the protrusions 19.

The bottom surface of the electrode layer 13 may be formed in the shape corresponding to the shape of the concave-convex structure formed on the top surface of the contact layer 11.

The protrusion 19 of the electrode layer 13 may make contact with the bottom surface of the groove 23, and the bottom surface of the electrode layer 13 except for the protrusion 19 may make contact with the top surface of the pattern 11a.

Accordingly, the electrode layer 13 more securely makes contact with the contact layer 11, thereby preventing the electrode layer 13 from peeling off the light emitting structure 9. Therefore, as the concave-convex structure 19 is formed on the bottom surface of the electrode layer 13, light can be more easily extracted to the outside, so that the light extraction efficiency can be improved.

Although the hole or the groove may be formed through an etching process, the embodiment is not limited thereto.

According to the second and third embodiments, the width of the pattern 11a of the contact layer 11 may be equal to or wider than the width of the hole 21 or the groove 23 between the patterns 11a. For example, the width of the pattern 11a of the contact layer 11 is wider than the width of the hole 21 or the groove 23 between the patterns 11a to increase the contact area between the contact layer 11 and the light emitting structure 9, thereby minimizing the contact resistance between the electrode layer 13 and the light emitting structure 9.

The hole 21 and the groove 23 may be called "recess".

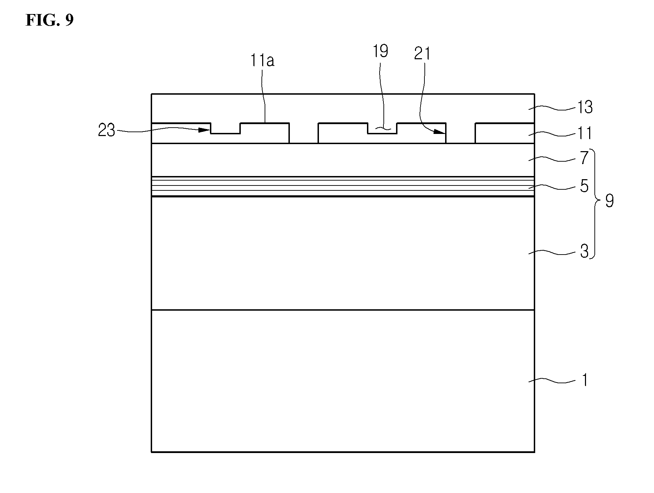

FIG. 9 is a sectional view showing a light emitting device according to a fourth embodiment.

As shown in FIG. 9, the fourth embodiment combines the second embodiment with the third embodiment.

In other words, the contact layer 11 comprises a plurality of holes 21 and a plurality of grooves 23. The details of the holes 21 and the grooves will be understood in the descriptions in FIGs. 5 and 8.

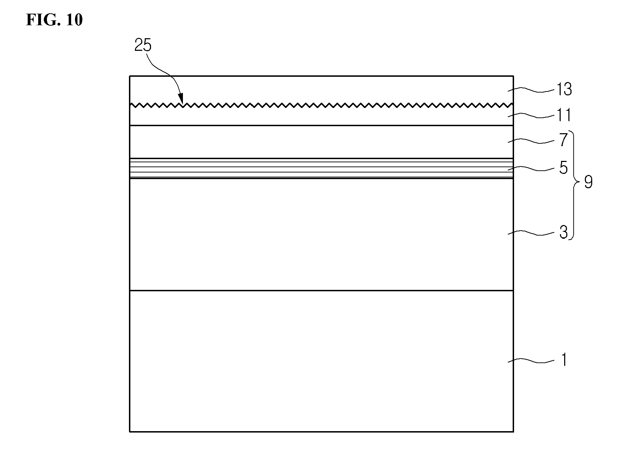

FIG. 10 is a sectional view showing a light emitting device according to the fifth embodiment.

The fifth embodiment is similar to the first embodiment except that the contact layer 11 includes a concave-convex structure 25. The same reference numerals will be assigned to elements according to the fifth embodiment having functions, shapes and/or materials the same as those of elements according to the first embodiment, and the details thereof will be omitted.

As shown in FIG. 10, according to the light emitting device of the fifth embodiment, the contact layer 11 may be provided between the second conductive semiconductor layer 11 of the light emitting structure 9 and the electrode layer 13.

The top surface of the contact layer 11 may include the concave-convex structure 25. The concave-convex structure 25 may be formed from the contact layer 11. In other words, the tops surface of the contact layer 11 is partially removed by etching the top surface of the contact layer 11, so that the concave-convex structure 25 may be formed.

Although not shown in drawings, the concave-convex structure may be formed separately from the contact layer 11.

The concave-convex structure 25 may be randomly or uniformly formed.

Since the electrode layer 13 is provided on the concave-convex structure 25, the bottom surface of the electrode layer 13 may have the shape corresponding to that of the concave-convex structure 25.

Since the light generated from the light emitting structure 9 is easily extracted to the outside by the concave-convex structure 25, the light extraction efficiency can be improved.

Accordingly, the contact area between the electrode layer 13 and the contact layer 11 is increased due to the concave-convex structure 25, so that the electrode layer 13 may make stronger contact with the contact layer 11.

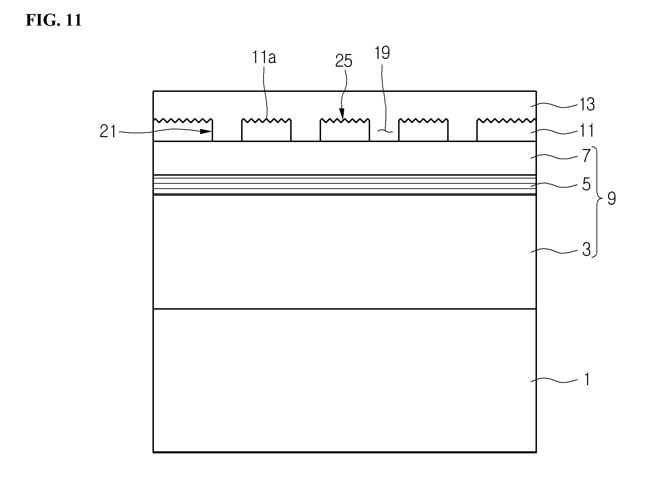

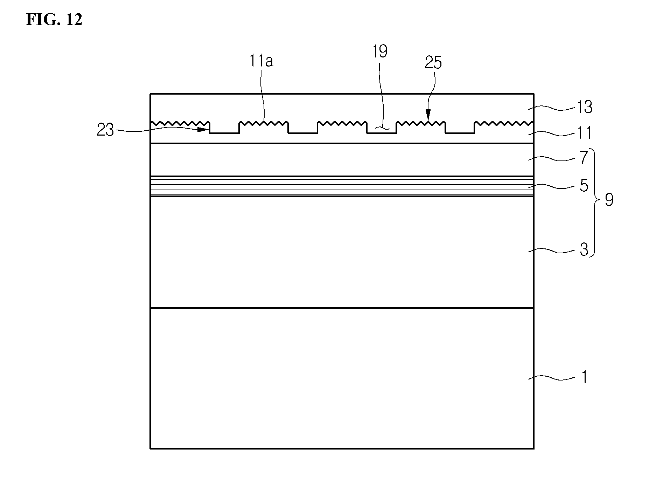

FIG. 11 is a sectional view showing a light emitting device according to a sixth embodiment, and FIG. 12 is a sectional view showing a light emitting device according to a seventh embodiment.

The sixth embodiment is similar to the second embodiment, and the seventh embodiment is similar to the third embodiment. In other words, the sixth embodiment has a feature that the concave-convex structure 25 is formed on the contact layer 11 according to the second embodiment, and the seventh embodiment has a feature that the concave-convex structure 25 is formed on the contact layer 11 according to the third embodiment.

The same reference numerals will be assigned to elements according to the sixth or seventh embodiment having functions, shapes and/or materials the same as those of elements according to the second or third embodiment, and the details thereof will be omitted.

According to the sixth embodiment, the concave-convex structure 25 may be formed on the top surface of the contact layer 11 except for the hole 21.

According to the seventh embodiment, the concave-convex structure 25 may be formed on the top surface of the contact layer 11 except for the groove 23.

The concave-convex structure 25 may be formed by etching the top surface of the contact layer 11 or may be formed separately from the contact layer 11.

The light emitting devices according to the first to seventh embodiments may be employed for the lateral-type light emitting device. In addition, the light emitting devices according to the first to seventh embodiments may be employed for a flip-chip type light emitting device or a vertical type light emitting device.

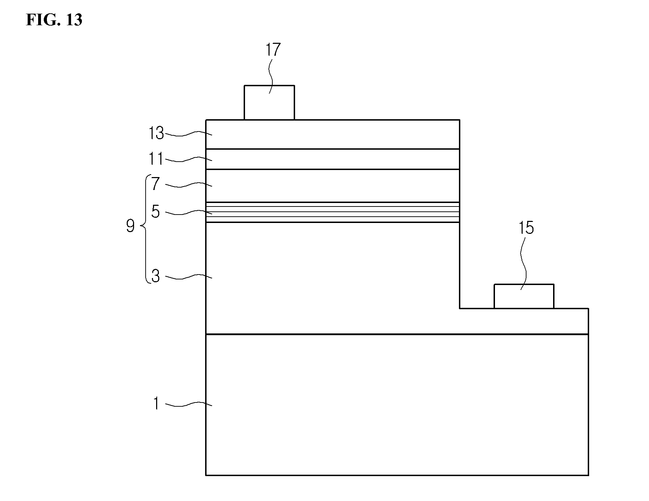

FIG. 13 is a sectional view showing a lateral-type light emitting device according to the first embodiment. The lateral-type light emitting device additionally includes first and second electrodes 15 and 17. The lateral-type light emitting device is substantially the same as the light emitting device according to the embodiment of FIG. 1 except that a portion of the light emitting structure 9 is removed in order to form the first electrode 15. Therefore, the same reference numerals will be assigned to elements of the lateral-type light emitting device having the same functions as those of the light emitting device according to the embodiment of FIG. 1, and the details thereof will be omitted.

Meanwhile, those skilled in the art can easily understand the features of elements, which are not described hereinafter, based on the light emitting device according to the embodiment of FIG. 1.

Referring to FIG. 13, the lateral-type light emitting device may include the substrate 1, the light emitting structure 9 provided on the substrate 1, the electrode layer 13 provided on the light emitting structure 9, the contact layer 11 between the light emitting structure 9 and the electrode layer 13, the first electrode 15 provided in a first region of the light emitting structure 9, and the second electrode 17 provided at a second region of the light emitting structure 9.

Although the light emitting structure 9 may include a plurality of compound semiconductor layers including at least the first conductive semiconductor layer 3, the active layer 5, and the second conductive semiconductor layer 7, the embodiment is not limited thereto.

In this case, the first region may be one region of a top surface of the first conductive semiconductor layer 3, and the second region may be one region of a top surface of the second conductive semiconductor layer 7, but the embodiment is not limited thereto.

In order to expose the first region of the top surface of the first conductive semiconductor layer 3, portions of the second conductive semiconductor layer 7 and the active layer 5 may be etched and removed. A portion of the top surface of the first conductive semiconductor layer 3 may be removed in the above etching process, but the embodiment is not limited thereto.

The first electrode may be formed at the first region of the top surface of the first conductive semiconductor layer 3, and the second electrode 17 may be formed at the second region of the top surface of the electrode layer 13.

For example, the first and second electrodes 15 and 17 may include one selected from the group consisting of Al, Ti, Cr, Ni, Pt, Au, W, Cu and Mo, or the lamination layers thereof, but the embodiment is not limited thereto.

If power is applied to the first and second electrodes 15 and 17, current may flow through the light emitting structure 9 between the first and second electrodes 15 and 17, and the light may be generated from the active layer 5 of the light emitting structure 9 due to the current.

Due to the electrode layer 13 provided under the second electrode 17, current is spread through the entire region of the electrode layer 13 to uniformly flow from the entire region of the electrode layer 13 to the entire region of the active layer 5 of the light emitting structure 9. Accordingly, as the current uniformly flows through the entire region of the active layer 5 without being concentrated on a portion of the active layer 5, light is uniformly generated, and the light emission efficiency of the whole light emitting device can be improved.

The contact resistance between the electrode layer 13 and the light emitting structure 9 is minimized due to the contact layer 11 provided under the electrode layer 13 so that driving voltage can be reduced.

In addition, current can be more easily introduced into the light emitting structure 9 by the contact layer 11, so that the light emission efficiency can be improved.

Further, the concave-convex structure 19 is formed on the bottom surface of the electrode layer 13 by patterning the contact layer 11, and the light extraction efficiency can be improved due to the concave-convex structure 19.

Although not shown in drawings, the lateral-type light emitting device of FIG. 13 may be employed to a light emitting package. The light emitting device package may include a body, at least one lead electrode on the body, and the lateral-type light emitting device of FIG. 13 on the lead electrode or the body. The light emitting device package may further include a molding member provided on the body to surround the lateral-type light emitting device, but the embodiment is not limited thereto.

The light emitting device package or the lateral-type light emitting device of FIG. 13 may be used as a light source for a display, a vehicle, or a lighting device, but the embodiment is not limited thereto.

## Claims

1. A light emitting device, comprising:
a light emitting structure comprising at least a first conductive semiconductor layer, an active layer, and a second conductive semiconductor layer;
an electrode layer on the light emitting structure; and
a contact layer between the light emitting structure and the electrode layer and comprising a nitride semiconductor layer.

2. The light emitting device of claim 1, wherein the contact layer comprises dopants.

3. The light emitting device of claim 1 or claim 2, wherein the contact layer comprises a semiconductor material the same as that constituting one of the first and second conductive semiconductor layers.

4. The light emitting device of any one of the preceding claims, wherein the contact layer has a thickness in a range of 15 Å to 30 Å.

5. The light emitting device of any one of the preceding claims, wherein the contact layer has doping concentration in a range of 0.7×10¹⁸ cm⁻³ to 3×10¹⁸ cm⁻³.

6. The light emitting device of any one of the preceding claims, wherein the contact layer comprises a plurality of recesses and a plurality of patterns provided among the recesses and connected to each other.

7. The light emitting device of claim 6, wherein each recess includes at least one of a hole and a groove.

8. The light emitting device of claim 7, wherein the electrode layer has a bottom surface comprising a plurality of protrusions.

9. The light emitting device of claim 7, wherein the groove has a depth corresponding to 30% to 90% with respect to a thickness of the contact layer.

10. The light emitting device of claim 6, wherein the width of the pattern is equal to or wider than the width of the recess.

11. The light emitting device of any one of the preceding claims, wherein the contact layer has a stripe shape or a lattice shape.

12. The light emitting device of any one of the preceding claims, further comprising:
a concave-convex structure on the contact layer.

13. The light emitting device of claim 12, wherein a bottom surface of the electrode layer has a shape corresponding to a shape of the concave-convex structure.

14. The light emitting device of any one of the preceding claims, wherein the contact layer has doping concentration lower than doping concentration of the second conductive semiconductor layer.

15. The light emitting device of any one of the preceding claims, wherein the electrode layer comprises one of a transmissive conductive material and a reflective conductive material.
